# EUROPÄISCHE PATENTSCHRIFT

(11) **EP 0 430 343 B1**
(45) Veröffentlichungstag und Bekanntmachung des Hinweises auf die Patenterteilung: **13.10.1993**
(21) Anmeldenummer: 90203054.3
(22) Anmeldetag: 19.11.1990
(51) Int. Cl.: H03L 7/14

(54) **Digitaler Phasenregelkreis**
Digital phase locked loop
Circuit bouclé à verrouillage de phase numérique

(30) Priorität: 24.11.1989 DE 3938886
(43) Veröffentlichungstag der Anmeldung: 05.06.1991
(73) Patentinhaber: Philips Patentverwaltung GmbH, 22335 Hamburg (DE); Philips Electronics N.V., 5621 BA Eindhoven (NL)
(72) Erfinder: Pletz-Kirsch, Gerhard, W-2000 Hamburg 62 (DE); Lenth, Jürgen, W-2000 Hamburg 54 (DE)
(74) Vertreter: von Laue, Hanns-Ulrich, Dipl.-Ing.

(56) Entgegenhaltungen:
- EP-A- 0 378 190
- EP-A- 0 391 464
- DE-A- 2 720 432
- US-A- 3 882 412

## Beschreibung

Die Erfindung betrifft einen digitalen Phasenregelkreis mit einem Phasenkomparator, einem steuerbaren Oszillator, dessen Ausgangssignal in dem Phasenkomparator mit einem Eingangssignal verglichen wird, und einem dem Oszillator vorgeschalteten Schleifenfilter, welches ein getaktetes Eingangsregister zur Speicherung des jeweils letzten Phasenmeßwertes des Phasenkomparators und einen Integrator aufweist, in dem ein getaktetes Register vorgesehen ist, dessen Ausgangssignal auf dem Registereingang rückgekoppelt ist.

Bei Phasenregelkreisen, die meist als Phase-Locked-Loop (PLL) bezeichnet werden, besteht das Problem, daß bei fehlendem oder gestörtem Eingangssignal des Phasenkomparators, in dem dieses Eingangssignal mit dem Ausgangssignal des steuerbaren Oszillators verglichen wird, der Phasenkomparator ein falsches bzw. zufälliges Ausgangssignal liefert, was dann dazu führt, daß der steuerbare Oszillator in seiner Frequenz hin- und herläuft oder auf sein Minimum bzw. Maximum läuft. Diese Effekte sind jedoch unerwünscht; es ist vielmehr wünschenswert, daß der Oszillator auf seiner Nennfrequenz schwingt.

Für einen analogen Phasenregelkreis ist aus der US-A-38 82 412 eine Schaltungsanordnung bekannt, welche bei fehlendem Eingangssignal des Phasenkomparators versucht, den Oszillator auf der zuletzt eingestellten Frequenz zu halten. Dies geschieht mittels einer digitalen Schaltung, welche den jeweils letzten aktuellen Meßwert speichert und bei fehlendem Eingangssignal in den Phasenregelkreis einspeist. Eine derartige Anordnung ist jedoch für digitale Schleifenfilter nicht anwendbar; dies gilt insbesondere für digitale Schleifenfilter, welche eine Rekursivfunktion aufweisen.

Es ist Aufgabe der Erfindung, einen digitalen Phasenregelkreis zu schaffen, dessen steuerbarer Oszillator auch bei nicht vorhandenem oder gestörtem Eingangssignal des Phasenkomparators ein Signal einer definierten Frequenz abgibt.

Diese Aufgabe ist erfindungsgemäß dadurch gelöst, daß bei fehlendem oder gestörtem Eingangssignal des Phasenkomparators ein Schaltsignal erzeugt wird, das die sofortige Löschung des Eingangsregisters im Schleifenfilter auslöst und nach dessen Erscheinen das Register im Integrator des Schleifenfilters innerhalb einer begrenzten Anzahl von Taktzyklen auf Null zurückgesetzt wird.

Ist das dem Phasenkomparator zugeführte Eingangssignal gestört, beispielsweise verrauscht, oder nicht vorhanden, so liefert der Phasendiskriminator stark schwankende Werte oder, je nach Bauart des Phasendiskriminators, immer wieder das letzte Phasenmeßergebnis. Um die sich daraus ergebenden Konsequenzen (falsche bzw. hin und her laufende Frequenz des Oszillators) zu vermeiden, wird das Eingangsregister des Schleifenfilters sofort gelöscht. Ist das Schleifenfilter so aufgebaut, daß es neben dem Integralanteil auch noch einen Proportionalanteil liefert, so wird dieser Proportionalanteil mit der Löschung des Eingangsregisters des Schleifenfilters auf Null zurückgeführt.

Der in dem Schleifenfilter vorgesehene Integrator würde jedoch auch nach Löschung des Eingangsregisters weiterhin ein Ausgangssignal liefern, nämlich dasjenige Signal, welches er vor der Löschung des Eingangsregisters lieferte. Es ist daher vorgesehen, daß nach Auftreten des Schaltsignals das Register im Integrator zurückgesetzt wird. Dies muß nicht sofort geschehen, jedoch spätestens innerhalb einer begrenzten Anzahl von Taktzyklen. Das Rücksetzen kann dabei auch stufenweise vorgenommen werden; das Register muß also nicht innerhalb eines Taktzyklus vollständig gelöscht werden.

Ist auch das Register des Integrators gelöscht, so liefert das Schleifenfilter kein Ausgangssignal bzw. das Ausgangssignal Null, so daß der nachgeschaltete steuerbare Oszillator auf seiner Nennfrequenz schwingt.

Zur Gewinnung des Schaltsignals kann beispielsweise der Pegel des Eingangssignals herangezogen werden.

Ein digitaler Phasenregelkreis dieser Art ist beispielsweise vorteilhaft einsetzbar in einem Fernsehempfänger, dessen für die Steuerung der horizontalen Ablenkung vorgesehener Phasenregelkreis nach der Erfindung ausgelegt sein kann. Für einen Fernsehempfänger ergibt sich dabei zusätzlich der Vorteil, daß bei fehlendem oder verrauschtem Eingangssignal die Horizontalablenkung auf Nennfrequenz arbeitet, so daß Bild- bzw. Schrifteinblendungen weiterhin möglich sind. Für Fernseh-Anwendungen kann das Schaltsignal beispielsweise in Abhängigkeit davon generiert werden, ob eine korrekte Erkennung der Synchronisations-Impulse erfolgt oder nicht.

Nach einer weiteren Ausgestaltung der Erfindung ist vorgesehen, daß das Schaltsignal eine sofortige Löschung des Registers im Integrator auslöst. In diesem Falle wird das Ausgangssignal des Schleifenfilters unmittelbar nach dem Auftreten des Schaltsignals auf Null zurückgesetzt, da auch der Integrator kein Ausgangssignal mehr liefert.

Nach einer weiteren Ausgestaltung der Erfindung ist vorgesehen, daß ab Erscheinen des Schaltsignals das Ausgangssignal des Registers im Integrator nach Multiplikation mit einem negativen Faktor auf den Registereingang rückgekoppelt ist.

Wird das Ausgangssignal des Registers im Integrator nach Erscheinen des Schaltsignals nach Multiplikation mit einem negativen Faktor auf den Registereingang rückgekoppelt, so wird der Registerinhalt über mehrere Taktzyklen hinweg verringert bis er den Wert Null erreicht. Dies hat zur Folge, daß das Ausgangssignal des Integrators und damit auch das des Schleifenfilters langsam auf Null zurückgeführt wird. Dies ist insbesondere für solche Anwendungen von Vorteil, in denen schnelle Änderungen der Frequenz des Oszillators unerwünscht sind. Dies gilt beispielsweise für den oben erwähnten Fall des Fernsehempfängers, in dem die Horizontalfrequenz sich nur langsam ändern darf, damit die Horizontal-Ablenk-Endstufen nicht überlastet werden.

Anhand der Zeichnungen werden zwei Ausführungsbeispiele der Erfindung näher erläutert. Es zeigen:
Fig. 1 einen digitalen Phasenregelkreis einer ersten Ausführungsform, in der das Register des Integrators nach Auftreten des Schaltsignals sofort gelöscht wird und
Fig. 2 einen digitalen Phasenregelkreis einer zweiten Ausführungsform, bei der die Löschung des Registers im Integrator über mehrere Taktzyklen hinweg erfolgt.

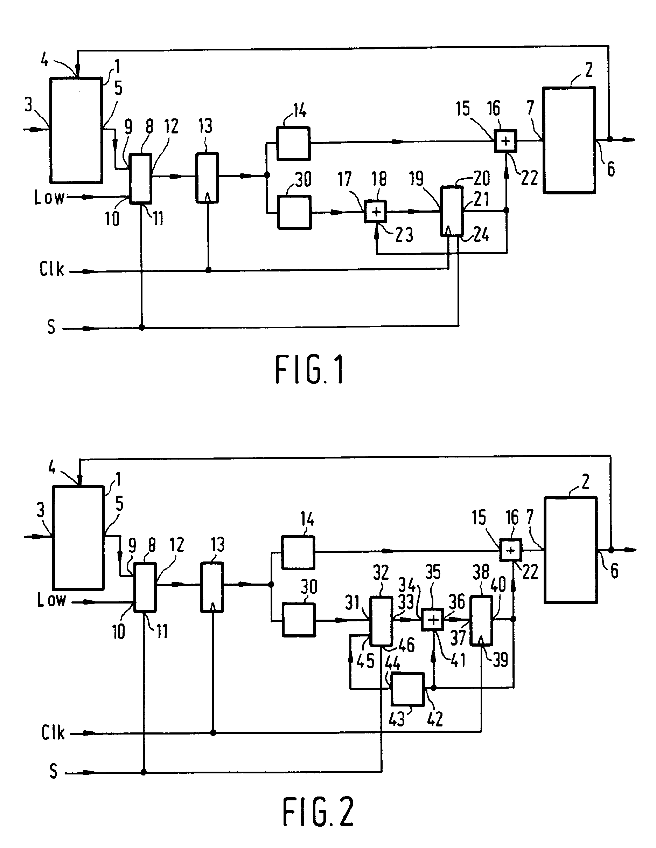

Ein in Fig. 1 dargestellter Phasenregelkreis weist einen Phasenkomparator 1 und einen steuerbaren Oszillator 2 auf, welche in bekannter Weise arbeiten und in der Figur nur schematisch dargestellt sind. Der Phasenkomparator 1 weist einen ersten Eingang 3 auf, an dem ein Eingangssignal anliegt, das in dem Phasenkomparator mit einem zweiten Eingang 4 anliegenden Signal auf Frequenz und Phasenlage verglichen wird. Das sich dabei ergebende Meßergebnis stellt der Phasenkomparator an seinem Ausgang 5 zur Verfügung. Das an seinem Eingang 4 anliegende Signal, das mit dem am Eingang 3 anliegenden Eingangssignal verglichen wird, ist das an einem Ausgang 6 des Oszillators erscheinende Signal, das gleichzeitig auch das Ausgangssignal des digitalen Phasenregelkreises darstellt.

Das an dem Ausgang 5 des Phasenkomparators 1 erscheinende Ausgangssignal ist einem in der Figur detailliert dargestellten Schleifenfilter zugeführt, in dem das Signal gefiltert wird, bevor es dem steuerbaren Oszillator 2 an einem Eingang 7 zur Verfügung gestellt wird.

Das Schleifenfilter dient vor allem dazu, die Eigenschaften des digitalen Phasenregelkreises in gewünschter Weise zu beeinflussen.

Das digitale Schleifenfilter weist an seinem Eingang einen Multiplexer 8 auf, dessen erster Eingang 9 mit dem Ausgang 5 des Phasenkomparators 1 verbunden ist. Einem zweiten Eingang 10 des Multiplexers 8 ist ein festes Low-Signal zugeführt. Einem weiteren Eingang 11 des Multiplexers ist ein Schaltsignal S zugeführt, in dessen Abhängigkeit der Multiplexer entweder das an seinem Eingang 9 oder das an seinem Eingang 10 zur Verfügung gestellte Eingangssignal auf einen Ausgang 12 des Multiplexers 8 geschaltet wird. Dies geschieht in der Weise, daß bei Low-Pegel des Schaltsignals S der erste Eingang 9 auf den Ausgang 12 und bei High-Pegel des Schaltsignals S der zweite Eingang 10 auf den Ausgang 12 des Multiplexers 8 geschaltet wird.

Das am Ausgang 12 des Multiplexers 8 auftretende Signal ist einem Eingangsregister 13 des Schleifenfilters zugeführt. Das Eingangsregister 13 ist mittels eines Taktsignals Clk getaktet. Das Ausgangssignal des Eingangsregisters 13 ist einem ersten Multiplizierer 14, sowie einem zweiten Multiplizierer 15 zugeführt. Das Ausgangssignal des Mulitplizierers 14 ist einem ersten Eingang 15 eines Addierers 16 verbunden.

Das Ausgangssignal des Multiplizierers 15 ist auf einen ersten Eingang 17 eines weiteren Addierers 18 geführt. Das Ausgangssignal des Addierers 18 ist auf einen Eingang 19 eines Registers 20 geführt. Ein Ausgang 21 des Registers 20 ist einerseits mit einem zweiten Eingang 22 des Addierers 16 und andererseits mit einem zweiten Eingang 23 des Addierers 18 verbunden. Dem Register 20 ist ebenso wie dem Register 13 das Schaltsignal Clk zugeführt. An einem weiteren Eingang 24 ist dem Register 20, ebenso wie dem Multiplexer 8 das Schaltsignal S zugeführt. Mittels dieses Schaltsignals S wird das Register 20 gelöscht, wenn das Schaltsignal S von Low-Pegel auf High-Pegel wechselt.

Dieser, in Fig. 1 dargestellte digitale Phasenregelkreis arbeitet wie folgt:

In dem Komparator 1 wird das einem Eingang 3 zugeführte Eingangssignal bezüglich Frequenz und Phasenlage mit dem Ausgangssignal des Oszillators 2 verglichen. Weist dieses Eingangssignal einen ausreichenden Pegel auf und es ist nicht gestört, so hat das Schaltsignal S Low-Pegel. Der Multiplexer 8 schaltet dann das Ausgangssignal des Phasenkomparators auf das Eingangsregister, in dem dieses, getaktet mittels des Signals Clk, eingelesen wird. Das Ausgangssignal des Registers 13 ist zum einen dem Multiplizierer 14 zugeführt, dessen Ausgang mit dem Addierer 16 verbunden ist. Auf diesem Wege gelangt zu dem Addierer 16, also zu dem Ausgang des Schleifenfilters, ein dem Ausgangssignal des Registers 13 proportionaler Wert. Ferner ist das Ausgangssignal einem Integrator zugeführt, der aus dem Addierer 18 und dem Register 20 aufgebaut ist. Dem Integrator ist ebenfalls ein Multiplizierer vorgeschaltet. Der Integrator arbeitet in der Weise, daß das von dem Multiplizierer 15 zur Verfügung gestellte Signal unter Addition des Ausgangssignals des Registers wieder in das Register eingelesen wird. Es ist hier also eine rekursive Funktion vorhanden. In dem Addierer 16 werden der von dem Multiplizierer 14 zur Verfügung gestellte Proportionalanteil und der von dem Integrierer zur Verfügung gestellte Integralanteil addiert und dem Oszillator 2 zugeführt. Mittels geeigneter Wahl der Faktoren der Multiplizierer 14 und 15 sind die Proportional- bzw. Integralanteile in ihrem Verhältnis zueinander einstellbar. Durch diese Einstellung können insbesondere die Dämpfung und die Eigenfrequenz des Schleifenfilters eingestellt werden.

In der bisherigen Funktionsbeschreibung wurde davon ausgegangen, daß das an dem Eingang 3 des Phasenkomparators 1 anliegende Eingangssignal einen ausreichenden Pegel hat und auch nicht gestört ist. Ist dies jedoch nicht der Fall, ist also das Eingangssignal nicht oder nicht mehr vorhanden oder gestört, z.B. verrauscht, so wird in an sich bekannter Weise ein Schaltsignal S erzeugt. In dem in der Figur dargestellten Ausführungsbeispiel wird davon ausgegangen, daß bei fehlendem oder gestörtem Eingangssignal des Phasenkomparators das Schaltsignal S von Low-Pegel auf High-Pegel wechselt. Es wird dann der Multiplexer 8 auf seinen zweiten Eingang 10 geschaltet. Dies führt dazu, daß das an diesem Eingang anliegende Low-Signal dem Register 13 zugeführt wird, in das es mit dem nächsten Takt des Taktsignals Clk eingelesen wird. Diese Löschung des Eingangsregisters 13 führt dazu, daß der Proportionalanteil sofort auf Null zurückgeführt wird. An dem Eingang 15 des Addierers 16 erscheint also nach Löschung des Eingangsregisters 13 sofort eine Null. Damit auch am Ausgang 21 des Registers 20, also am Ausgang des Integrators, eine Null erscheint, wird das Register 20 mittels des Schaltsignals S, das einem Eingang 24 zugeführt ist, gelöscht. Es wird damit auch der Integralanteil auf Null zurückgeführt. Auch in den weiteren Taktzyklen des Signals Clk bleibt der Registerinhalt des Integrators 20 auf Null stehen, so daß das Ausgangssignal des Addierers 16 und damit das dem steuerbaren Oszillator 2 an seinem Eingang 7 zur Verfügung gestellte Signal dauerhaft auf Null stehen bleibt. Dies führt dazu, daß der steuerbare Oszillator 2 auf seiner Nennfreuquenz schwingt.

Ein in Fig. 2 dargestellter digitaler Phasenregelkreis unterscheidet sich von dem in Fig. 1 dargestellten Phasenregelkreis vor allem dadurch, daß mit Auftreten des Schaltsignals S keine sofortige Löschung des Registers im Integrator vorgenommen wird, sondern daß dieses erst über mehrere Takte des Signals Clk hinweg stufenweise gelöscht wird.

Der in Fig. 2 dargestellte Phasenregelkreis ist bezüglich des Phasenkomparators 1, des Multiplexers 8, des Eingangsregisters 13, des Multiplizierers 14, des Multiplizierers 15, des Addierers 16 und des steuerbaren Oszillators 2 in gleicher Weise verschaltet wie der in Fig. 1 dargestellte Phasenregelkreis. Jedoch ist der Integrator des in der Fig. 2 dargestellten Phasenregelkreises in anderer Weise aufgebaut.

Das Ausgangssignal des Multiplizierers 15 ist auf einen ersten Eingang 31 eines Multiplexers 32 geschaltet. Ein Ausgang 33 des Multiplexers 32 ist auf einen ersten Eingang 34 eines Addierers 35 geschaltet, dessen Ausgang 36 mit einem Eingang 37 eines Registers 38 verbunden ist. Das Register 38 wird mittels des seinem Eingang 39 zugeführten Taktsignals Clk getaktet. Ein Ausgang 40 des Registers 38 ist mit dem zweiten Eingang 22 des Addierers 16, mit einem zweiten Eingang 41 des Addierers 35 und mit einem Eingang 42 eines Multiplizierers 43 verbunden. Ein Ausgang 44 des Multiplizierers 43 ist mit einem zweiten Eingang 45 des Multiplexers 32 verbunden. An einem Schalteingang 46 des Multiplexers 32 ist diesem das Schaltsignal S zugeführt.

Das in der Fig. 2 dargestellte Schleifenfilter arbeitet bezüglich des Multiplexers 8, des Eingangsregisters 13 und des Multiplizierers 14, mittels dessen dem Addierer 16 ein Proportionalanteil des Eingangssignals des Schleifenfilters zugeführt wird, in gleicher Weise wie das in Fig. 1 dargestellte Schleifenfilter. Der dem zweiten Eingang 22 des Addierers 16 zugeführte Integralanteil wird jedoch in etwas anderer Weise gewonnen.

Zunächst wird davon ausgegangen, daß das Schaltsignal S Low-Pegel hat, d.h. also, daß das Eingangssignal des Phasenkomparators 1 nicht gestört ist und ausreichenden Pegel aufweist. Dann ist der Multiplexer 32 auf seinen ersten Eingang 31 geschaltet. Das Ausgangssignal des Multiplexers 32 gelangt über den Addierer 35 zu dem Register 38, dessen Ausgangssignal ebenfalls dem Addierer 35 zugeführt ist. Insoweit ist die Funktionsweise des Integrators identisch mit der des in Fig. 1 dargestellten Integrators.

Wechselt jedoch das Schaltsignal S von Low-Pegel auf High-Pegel, so wird der Multiplexer 32 auf seinen zweiten Eingang 45 geschaltet, d.h. also, daß das an diesem Eingang anliegende Eingangssignal auf den Ausgang 33 geschaltet wird. Auf den ersten Eingang 34 des Addierers 35 gelangt nunmehr also das in dem Multiplizierer 43 mit einem negativen Faktor, der kleiner als -1 ist, multiplizierte Ausgangssignal des Registers 40. Da dem zweiten Eingang des Addierers 41 nach wie vor das unveränderte Ausgangssignal des Registers 38 zugeführt ist, liefert der Addierer 35 an seinem Ausgang 36 also ein Ausgangssignal, welches etwas kleiner ist als das Ausgangssignal des Registers 40. Da dieses Ausgangssignal des Addierers 36 mit jedem Takt Clk in das Register 38 eingelesen wird, wird der Speicherinhalt des Registers 38 mit jedem Taktzyklus etwas verringert. Das Maß der Verringerung ist einstellbar mittels des Faktors, mit dem der Multiplizierer 43 arbeitet. In jedem Falle muß jedoch der Faktor kleiner als -1 sein, da nur dann der Speicherinhalt des Registers 38 verringert wird. Mit der Wahl des Faktors ist beeinflußbar, nach welcher Zeit nach Ausfall oder Störung des dem Phasenkomparator 1 zugeführten Eingangssignals der steuerbare Oszillator 2 wieder auf seiner Nennfrequenz schwingt. Es ergibt sich also bei diesem Schleifenfilter der weitere Vorteil, daß nach Ausfall oder Störung des Eingangssignals der Oszillator langsam wieder auf die Nennfrequenz zurückgeführt wird. Die Zeit, in der dieses geschieht, ist mittels des Faktors des Multiplizierers 43 beeinflußbar.

Diese Eigenschaft des in Fig. 2 dargestellten digitalen Phasenregelkreises ist für viele Anwendungen bedeutsam, da oftmals eine zu schnelle Änderung der Frequenz des Ausgangssignals des Oszillators 2 nicht erwünscht ist. Dies gilt beispielsweise für Anwendungen in Fernsehempfängern, in denen die für die vertikale bzw. horizontale Ablenkung eingesetzten Phasenregelkreise ihre Frequenz nicht zu stark über der Zeit ändern dürfen, da andernfalls die Ablenkungs-Endstufen zu stark belastet werden.

## Patentansprüche

1. Digitaler Phasenregelkreis mit einem Phasenkomparator (1), einem steuerbaren Oszillator (2), dessen Ausgangssignal in dem Phasenkomparator (1) mit einem Eingangssignal verglichen wird, und einem dem Oszillator (2) vorgeschalteten Schleifenfilter, welches ein getaktetes Eingangsregister (13) zur Speicherung des jeweils letzten Phasenmeßwertes des Phasenkomparators und einen Integrator aufweist, in dem ein getaktetes Register (20, 38) vorgesehen ist, dessen Ausgangssignal auf dem Registereingang (19, 37) rückgekoppelt ist, dadurch gekennzeichnet, daß bei fehlendem oder gestörtem Eingangssignal des Phasenkomparators (1) ein Schaltsignal erzeugt wird, das die sofortige Löschung des Eingangsregisters (13) im Schleifenfilter auslöst und nach dessen Erscheinen das Register (20, 38) im Integrator des Schleifenfilters innerhalb einer begrenzten Anzahl von Taktzyklen auf Null zurückgesetzt wird.

2. Digitaler Phasenreglekreis nach Anspruch 1, dadurch gekennzeichnet, daß das Schaltsignal eine sofortige Löschung des Registers (20) im Integrator auslöst.

3. Digitaler Phasenregelkreis nach Anspruch 1, dadurch gekennzeichnet, daß ab Erscheinen des Schaltsignals das Ausgangssignal des Registers (38) im Integrator nach Multiplikation mit einem negativen Faktor auf den Registereingang (37) rückgekoppelt ist.

4. Digitaler Phasenregelkreis nach Anspruch 3, dadurch gekennzeichnet, daß dem Register (38) im Integrator ein Addierer (35) vorgeschaltet ist, dem das Ausgangssignal des Registers (38) und das Ausgangssignal eines Multiplexers (32) zugeführt sind, der einen ersten Eingang (31), dem das zu integrierende Signal zugeführt ist, und einem zweiten Eingang (45) aufweist, dem das mit einem negativen Faktor, welcher kleiner als -1 ist, multiplizierte Ausgangssignal des Integrators zugeführt ist und daß der Multiplexer (32) während der Dauer des Schaltsignals das seinem zweiten Eingang (45) zugeführte Signal und während der übrigen Zeiten das seinem ersten Eingang (31) zugeführte Signal auf seinen Ausgang (33) schaltet.

## Claims

1. A digital phase-locked loop comprising a phase comparator (1), a controllable oscillator (2) whose output signal is compared with an input signal in the phase comparator (1), and a loop filter preceding the oscillator (2), which filter comprises a clocked input register (13) for storing the last phase-measuring value of the phase comparator, and an integrator which comprises a clocked register (20, 38) whose output signal is fed back to the register input (18, 37), characterized in that in the absence of the input signal of the phase comparator (1) or in the case of a disturbed input signal a switching signal is generated which immediately erases the input register (13) in the loop filter and after whose appearance the register (20, 38) in the integrator of the loop filter is reset to zero within a limited number of clock cycles.

2. A digital phase-locked loop as claimed in Claim 1, characterized in that the switching signal immediately erases the register (20) in the integrator.

3. A digital phase-locked loop as claimed in Claim 1, characterized in that from the instant of appearance of the switching signal the output signal of the register (38) in the integrator is fed back to the register input (37) after multiplication by a negative factor.

4. A digital phase-locked loop as claimed in Claim 3, characterized in that the register (38) in the integrator is preceded by an adder (35) to which the output signal of the register (38) and the output signal of a multiplexer (32) are applied, which multiplexer has a first input (31) to which the signal to be integrated is applied, and a second input (45) to which the output signal of the integrator multiplied by a negative factor which is smaller than -1 is applied, and in that the output (33) of the multiplexer (32) conveys the signal applied to its second input (45) during the period of the switching signal and the signal applied to its first input (31) during the other periods.

## Revendications

1. Circuit numérique de réglage de phase comportant un comparateur de phase (1), un oscillateur commandable (2) dont le signal de sortie est comparé, dans le comparateur de phase (1), avec un signal d'entrée, et un filtre de boucle précédant l'oscillateur (2) et présentant un registre d'entrée rythmée (13) pour mémoriser chaque dernière valeur de mesure de phase du comparateur de phase ainsi qu'un intégrateur dans lequel est prévu un registre rythmé (20, 38) dont le signal de sortie est rétrocouplé à l'entrée du registre (19, 37), caractérisé en ce qu'en l'absence du signal d'entrée du comparateur de phase (1) ou lors d'une perturbation de celui-ci, est engendré un signal de commutation qui provoque l'effacement immédiat du registre d'entrée (13) du filtre de boucle et après l'apparition duquel le registre (20, 38) de l'intégrateur du filtre de boucle est remis à zéro dans un nombre limité de cycles d'horloge.

2. Circuit numérique de réglage de phase selon la revendication 1, caractérisé en ce que le signal de commutation provoque un effacement immédiat du registre (20) de l'intégrateur.

3. Circuit numérique de réglage de phase selon la revendication 1, caractérisé en ce qu'à partir de l'instant d'apparition du signal de commutation, le signal de sortie du registre (38) de l'intégrateur est rétrocouplé à l'entrée (37) du registre après multiplication par un facteur négatif.

4. Circuit numérique de réglage de phase selon la revendication 3, caractérisé en ce que le registre (38) de l'intégrateur est précédé d'un additionneur (35) recevant le signal de sortie du registre (38) et le signal de sortie d'un multiplexeur (32) qui présente une première entrée (31) à laquelle est appliqué le signal devant être intégré, et une seconde entrée (45) à laquelle est appliqué le signal de sortie de l'intégrateur, multiplié par un facteur négatif, inférieur à -1, et en ce que le multiplexeur (32) transfère vers sa sortie (33), pendant la durée du signal de commutation, le signal appliqué à sa seconde entrée (45) et, pendant les autres durées, le signal appliqué à sa première entrée (31).
